(19) **Europäisches Patentamt**
**European Patent Office**
**Office européen des brevets**

(11) Publication number: **0 223 473 B1**

(12) # EUROPEAN PATENT SPECIFICATION

(45) Date of publication of patent specification: **16.10.91**

(51) Int. Cl.5: **C30B 7/10, C30B 29/10**

(21) Application number: **86308539.5**

(22) Date of filing: **03.11.86**

(54) **Method of manufacturing calcium carbonate single crystals.**

(30) Priority: **12.11.85 JP 253124/85**

(43) Date of publication of application:
**27.05.87 Bulletin 87/22**

(45) Publication of the grant of the patent:
**16.10.91 Bulletin 91/42**

(84) Designated Contracting States:
**DE FR GB**

(56) References cited:

**JOURNAL OF CRYSTAL GROWTH, vol. 24/25, 1974, pages 610-613, North-Holland Publishing Co., Amsterdam, NL; D.R. KINLOCH et al.: "Hydrothermal growth of calcite in large autoclaves"**

**MANUFACTURING TECHNOLOGY NOTE, no. R11-599, March 1978, Office of manufacturing technology, alexandria, Virginia, US; "Growth of synthetic calcite crystals"**

(73) Proprietor: **SEIKO INSTRUMENTS INC.**
**31-1, Kameido 6-chome Koto-ku**
**Tokyo 136(JP)**

Proprietor: **Hirano, Shinichi**
**2-66, Yada-cho Higashi-ku**
**Nagoya-shi Aichi(JP)**

(72) Inventor: **Hirano, Shinichi**
**66, Yada-cho 2-chome Higashi-ku**
**Nagoya-shi Aichi(JP)**
Inventor: **Toyukuni, Ryo /Seiko Instr. & Electr. Ltd.**
**31-1, Kameido 6-chome Koto-ku**
**Tokyo(JP)**
Inventor: **Kuroda, Hiroshi Seiko Instr. & Electr. Ltd.**
**31-1, Kameido 6-chome Koto-ku**
**Tokyo(JP)**

(74) Representative: **Miller, Joseph et al**
**J. MILLER & CO. Lincoln House 296-302 High Holborn**
**London WC1V 7JH(GB)**

Rank Xerox (UK) Business Services

## Description

This invention relates to methods of manufacturing calcium carbonate single crystals (calcite) widely used in optical polarisers, etc.

Single crystals of calcium carbonate ($CaCO_3$) have optical uses and for this purpose natural calcite crystals are currently used. Calcite single crystals exhibit double refraction of incident light. Calcite has a high refractive index and so it is used as a polarising prism in optical apparatus. Because of recent advances in the design of apparatus such as laser optics and optical communication apparatus, etc. there is an increased market for a material with excellent optical characteristics. In this regard, calcite single crystals are an ideal material, and are expected to be more and more in demand.

Calcite single crystals are obtainable only from natural sources because they are not yet being industrially synthesised. To be of commercial use, natural calcite must be colourless, transparent, have no bubbles or cracks, no twining, no internal strains and be greater than a certain size. However, calcite single crystals that will meet these requirements are found only in limited quantities in the Republic of South Africa, Mexico, etc. and reserves are running low.

There have been experiments to synthesise calcium carbonate single crystals. One way is by crystallisation from a solvent, another is synthesising from a gel, a third is crystalliation from a flux or melt, a fourth is hydrothermal synthesis, and recently an FZ method under high pressure has been suggested. However, optical characteristics such as transparency of resulting crystals have not been entirely satisfactory due to defects such as impurities, mixing, dislocations, inclusions, or internal strains.

Among the methods tried for the manufacture of calcium carbonate single crystals, hydrothermal synthesis is closest to the conditions under which natural calcite was grown in a hydrothermal ore deposit. Therefore, hydrothermal synthesis enables calcium carbonate single crystals with characteristics similar to natural calcite to be achieved. The hydrothermal synthesis process used to date for manufacture of calcium carbonate single crystals utilises an aqueous solvent at fixed temperature and pressure in an autoclave. Alkaline aqeuous solutions such as sodium hydroxide (NaOH) or alkali carbonate aqueous solutions such as sodium carbonate ($Na_2CO_3$), potassium carbonate ($K_2CO_3$), etc. are generally used as the aqueous solvent. Growth of calcium carbonate single crystals in this way is essentially an extension of conventional growth technology for artificial crystals. Under the following conditions:

Solvent - 6 mol $K_2CO_3$ aqueous solution
Temperature - 410°C to 445°C
Pressure - 1720 kg/cm² (1720 atmospheres)
Growth speed - 50 microns/day
about 3 mm growth layer of a calcium carbonate single crystal has been obtained.

Hydrothermal synthesis is disclosed in D.R. Kinlock H, R.F. Belt, R.C. Puttbac H, Journal of Crystal Growth 24/25 (1974) 610-613.

European Application No. 86301937.8 discloses a method of manufacturing calcium carbonate single crystals grown by hydrothermal synthesis using a chloride aqueous solution.

Calcium carbonate crystals can be grown from an alkali carbonate aqueous solution by a hydrothermal synthesis as described above, but there are problems. Firstly, due to the high concentration of solvent, inclusions frequently occur in the resulting crystals. These inclusions will result in inferior optical characteristics. Next, due to a high concentration of solvent it is impossible to achieve sufficient pressure for quantity production. In other words, the higher the solvent concentration, the lower the obtained pressure becomes even with the same filling up rate. In the case of a 6 mol concentration of $K_2CO_3$ aqueous solution at 445°C and a filling up rate of nearly 100%, it is impossible to obtain a pressure of 1720 kg/cm² (1720 atmospheres). Due to this, it is necessary to apply additional pressure from outside the autoclave, causing the apparatus and pressure system etc. to be too complicated. Using an alkali carbonate aqueous solution, the growth speed will be very slow, i.e. 50 microns/day and therefore it will take more or less a year to grow crystals large enough to be used as optical elements.

The present invention seeks to provide a simple method to grow relatively quickly excellent calcium carbonate single crystals with good optical characteristics.

According to the present invention there is provided a method of manufacturing calcium carbonate single crystals wherein the calcium carbonate single crystal is grown by hydro-thermal synthesis which applies heat and pressure to a starting material composed of calcium carbonate crystal within a solvent, characterised by using a nitrate solution as the solvent.

The nitrate aqueous solution may be an alkali nitrate aqueous solution, e.g. any one of sodium nitrate, potassium nitrate and lithium nitrate.

The temperature of the synthesis may be in the range of 300°C to 500°C, preferably higher than

2

370° C and preferably lower than 420° C.

The nitrate aqueous solution may be a 3 mol nitrate aqueous solution.

The pressure may be less than 1000 kg/cm$^2$ and preferably substantially 750 kg/cm$^2$.

The calcium carbonate single crystal may be deposited on a wall of a pressure vessel.

Alternatively, the calcium carbonate single crystal may be grown on a seed crystal.

In one preferred embodiment said hydrothermal synthesis is carried out in a pressure vessel, the starting material being placed at the bottom portion of said pressure vessel and a seed crystal being placed at the upper portion of said pressure vessel. Thus said seed crystal may be maintained substantially 50° C lower than said said bottom portion of the pressure vessel, said single crystal being grown on the seed crystal. A baffle may be located in the nitrate aqueous solution between the starting material and the seed crystal.

The invention is illustrated, merely by way of example, in the accompanying drawings, in which:-

Figure 1 is a sectional view of a test tube used in Example 1 according to the present invention; and

Figure 2 is a sectional view of a pressure vessel used in Example 2 according to the present invention.

The problems encountered in growing calcium carbonate single crystals by the prior hydrothermal synthesis, namely inferior optical quality, complicated apparatus, and lengthy growth period, etc. result from having to use a high concentration solvent and high pressure. In other words, the problems stem from the choice of solvent and growth conditions.

A nitrate aqueous solution has now been found best to avoid these problems, among various kinds of existing solvents such as alkaline, carbonate, acid and chloride solutions.

In the present invention, hydrothermal synthesis initiating or starting material is dissolved in a suitable aqueous solution of solvent at appropriate temperature and pressure, and crystallisation on a substrate occurs on gradually cooling or by transporting nourishment (material) through a temperature differential. The solvent should, therefore, be such that the starting material dissolves well in it and it should have little corrosive action on apparatus used. A nitrate aqueous solution as a solvent has been found to be ideal.

The invention is further described with reference to the following Examples.

EXAMPLE 1

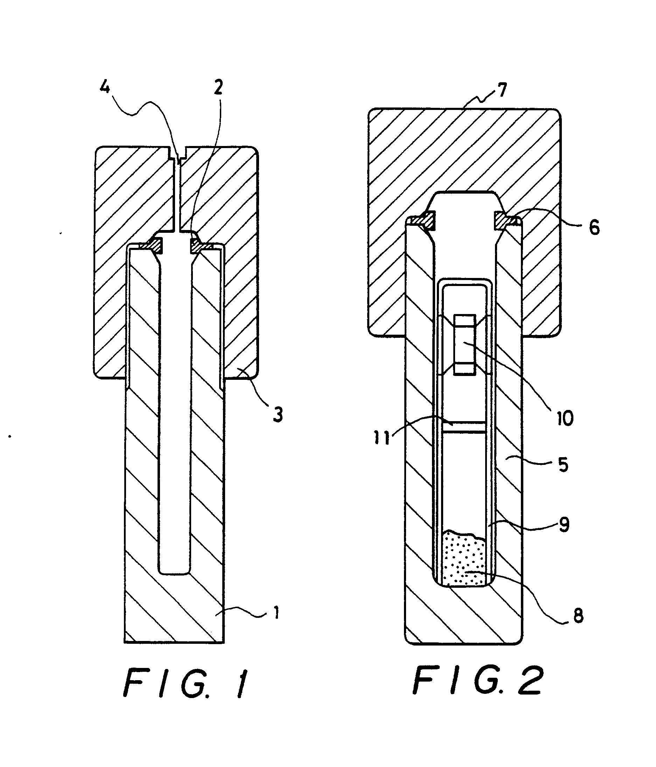

As starting material, commercially available calcium carbonate of high purity was used. For hydrothermal synthesis an autoclaval test tube of stellite quality No. 25 was used. Figure 1 shows the structure of the test tube having a pressure vessel body 1 with a cover 3 and a seal 2.

The inside temperature of the pressure vessel body is taken through a temperature measuring hole 4. A gold capsule, 3 mm - 5 mm in diameter was placed in the test tube. The starting material and solvent were poured into the test tube for hydrothermal synthesis. In this case the pressure between the inside and the outside of the capsule was balanced by filling the inside of the pressure vessel with distilled water.

The result using various solvents and the result of growing crystals using each solvent and the condition of the hydrothermal synthesis are shown in the following Table:-

| Solvent | Conditions of Hydrothermal Synthesis | | | Size of Crystal Obtained |
|---|---|---|---|---|
| 3Mol NaNO$_3$ | Temp. | 300°C | | 0.2 mm – 0.3 mm |
| | Pressure | 750 kg/cm$^2$ | | |
| | Growth Period | 7 days | | |
| 3Mol NaNO$_3$ | Temp. | 300°C | | 0.2 mm – 0.3 mm |
| | Pressure | 750 kg/cm$^2$ | | |
| | Growth Period | 7 days | | |
| 3Mol NaNO$_3$ | Temp. | 370°C | | 0.3 mm – 0.5 mm |
| | Pressure | 750 kg/cm$^2$ | | |
| | Growth Period | 7 days | | |
| 3Mol NaNO$_3$ | Temp. | 420°C | | 0.1 mm – 0.2 mm |
| | Pressure | 500 kg/cm$^2$ | | |
| | Growth Period | 7 days | | |
| 3Mol KNO$_3$ | Temp. | 400°C | | 0.5 mm – 0.6 mm |
| | Pressure | 750 kg/cm$^2$ | | |
| | Growth Period | 7 days | | |
| 3Mol KNO$_3$ | Temp. | 400°C | | 0.6 mm – 0.8 mm |
| | Pressure | 1000 kg/cm$^2$ | | |
| | Growth Period | 7 days | | |
| 3Mol LiNO$_3$ | Temp. | 380°C | | 0.3 mm – 0.5 mm |
| | Pressure | 750 kg/cm$^3$ | | |
| | Growth Period | 7 days | | |
| 3Mol LiNO$_3$ | Temp. | 420°C | | 0.6 mm – 1.0 mm |
| | Pressure | 750 kg/cm$^2$ | | |
| | Growth Period | 7 days | | |
| 3Mol | Temp. | 450°C | | 0.8 mm – 1.0 mm |
| | Pressure | 750 kg/cm$^2$ | | |
| | Growth Period | 7 days | | |

| Solvent | Conditions of Hydrothermal Synthesis | | Size of Crystal Obtained |
|---------|----------------|----------|--------------------------|
| 3Mol NaNO$_3$ | Temp. | 500°C | 1.0 mm – |
| | Pressure | 750 kg/cm$^2$ | 1.2 mm |
| | Growth Period | 7 days | |

In every case it was found that the crystals were grown using any one of $NaNO_3$, $KNO_3$ and $LiNO_3$ as the solvent. By making the concentration of nitrate in the aqueous solution relatively large, good crystal growth was achieved. However, it was found that a molecular concentration of about 3Mol was preferred bearing in mind the pressure and because it was easier to handle. As for pressure, unlike the case of using an alkali carbonate aqueous solution, it was possible to grow crystals using pressures less than 1000 kg/cm$^2$ and a very good crystal growth at pressures of around 750 kg/cm$^2$ were achieved. However, at a pressure of 500 kg/cm$^2$, crystalline growth was found to be very slow. As for temperature, it was possible to grow crystals in the range of 300°C to 500°C, preferably in the range of 370°C to 420°C. If the temperature was below 370°C it was still possible to grow crystals but the speed of growth was very slow. If the temperature was over 420°C it was still possible to grow crystals, however, there was the possibility of reduced quality.

It was identified by X-ray diffraction that in each case the crystals grown were calcium carbonate single crystals.

EXAMPLE 2

Figure 2 is a sectional view illustrating a typical test tube used in this Example. The test tube was made of stellite 25 as in Example 1, but the inside was lined with platinum in order to avoid contamination by pollutants. A pressure vessel body 5 was sealed with a cover 7 through a sealing ring 6. At the bottom of the pressure vessel body 5 starting material 8 for the crystals to be grown was placed. The starting material was as in Example 1 being refined and recrystallised in sodium nitrate ($NaNO_3$) and was powdered. A crystal support frame 9 carried a species or seed crystal 10 over the starting material 8. The seed crystal 10 was a calcite (1011) face crystal of natural optical grade. It is necessary to choose a seed crystal with few internal inclusions and little lattice displacement, etc. so that defects in the single crystal to be grown thereon can be avoided. A baffle 11 was provided between the starting material 8 and the seed crystal 10 and was supported on the frame 9. The inside of the pressure body 5 was filled up with 3 mol sodium nitrate ($NaNO_3$) aqueous solution as solvent at such a filling-up rate as to enable a predetermined temperature to be achieved.

Hydrothermal synthesis was conducted under the same conditions as in Example 1, namely;
Temperature of seed crystal 10 370°C
Temperature of starting material 8 420°C
Solvent - 3 Mol $NaNO_3$ aqueous solution
Pressure - 750 kg/cm$^2$
Growth Period - 50 days
As a result a calcium carbonate single crystal was grown on the seed crystal 10 as follows:
Thickness of grown layer 6.6 mm
Growth speed 132 microns/day
Character of grown layer: calcium carbonate single crystal (identified by X-ray diffraction)
Its optical characteristics were the same as those of natural calcite (from measurement of permeability rate, compound refractive index, etc.).

From the above discussion it will be appreciated that it is easier for growth of calcium carbonate single crystals to be industrialised by hydrothermal synthesis because a pressure less than 1000 kg/cm$^2$ is used and, at the same time, reducing defects inside the crystals grown, compared with the prior growth methods of calcium carbonate single crystals by using alkali carbonate aqueous solutions. In addition, the growth speed of the crystals is over twice that achieved with the prior method and this is a very favourable characteristic in the case of industrialisation. It is thus possible for calcium carbonate single crystals of optical grade quality equal to that of natural calcite to be made industrially by the same technology as that for the current artificial crystals. To be industrially able to produce such crystals equal in quality to natural

EP 0 223 473 B1

optical grade calcite will mean that it will be possible always to provide a market for such crystals with the same quality. Because of the dependence upon natural calcite, there has been no guarantee of either a regular supply or consistent quality. Industrialisation of calcium carbonate single crystals will achieve such consistency and enhance their use in optical elements and parts etc. used in a whole range of apparatus and will enable their characteristics to be improved.

## Claims

1. A method of manufacturing calcium carbonate single crystals wherein the calcium carbonate single crystal is grown by hydro-thermal synthesis which applies heat and pressure to a starting material composed of calcium carbonate crystal within a solvent, characterised by using a nitrate solution as the solvent.

2. A method as claimed in claim 1 characterised in that said nitrate solution is an alkali nitrate aqueous solution.

3. A method as claimed in claim 2 characterised in that said nitrate aqueous solution is any one of sodium nitrate, potassium nitrate and lithium nitrate.

4. A method as claimed in any preceding claim characterised in that the temperature of the synthesis is in the range of $300°C$ to $500°C$.

5. A method as claimed in any preceding claim characterised in that the temperature of the synthesis is higher than $370°C$.

6. A method as claimed in any preceding claim characterised in that the temperature of the synthesis is lower than $420°C$.

7. A method as claimed in any preceding claim characterised in that the nitrate aqueous solution is a 3 mol aqueous solution.

8. A method as claimed in any preceding claim characterised in that said pressure is less than 1000 $kg/cm^2$.

9. A method as claimed in claim 8 characterised in that the pressure is substantially 750 $kg/cm^2$.

10. A method as claimed in any preceding claim characterised in that the calcium carbonate single crystal is deposited on a wall of a pressure vessel.

11. A method as claimed in any of claims 1 to 9 characterised in that the calcium carbonate single crystal is grown on a seed crystal.

12. A method as claimed in any of claims 1 to 9 characterised in that said hydro-thermal synthesis is carried out in a pressure vessel, the starting material being placed at the bottom portion of said pressure vessel and a seed crystal being placed at the upper portion of said pressure vessel.

13. A method as claimed in claim 12 characterised in that said seed crystal is maintained substantially $50°C$ lower than said bottom portion of the pressure vessel, said single crystal being grown on the seed crystal.

14. A method as claimed in claim 12 or 13 characterised in that a baffle is located in the nitrate aqueous solution between the starting material and the seed crystal.

## Revendications

1. Un procédé de fabrication de monocristaux de carbonate de calcium, dans lequel on fait croître le monocristal de carbonate de calcium par une synthèse hydrothermique qui applique de la chaleur et une pression à une matière de départ consistant en un cristal de carbonate de calcium dans un solvant,

. 6

EP 0 223 473 B1

caractérisé par l'utilisation d'une solution de nitrate à titre de solvant.

2. Un procédé selon la revendication 1, caractérisé en ce que la solution de nitrate est une solution aqueuse d'un nitrate de métal alcalin.

3. Un procédé selon la revendication 2, caractérisé en ce que la solution aqueuse de nitrate est une solution de nitrate de sodium, de nitrate de potassium ou de nitrate de lithium.

4. Un procédé selon l'une quelconque des revendications précédentes, caractérisé en ce que la température de la synthèse est dans la plage de 300° C à 500° C.

5. Un procédé selon l'une quelconque des revendications précédentes, caractérisé en ce que la température de la synthèse est supérieure à 370° C.

6. Un procédé selon l'une quelconque des revendications précédentes, caractérisé en ce que la température de la synthèse est inférieure à 420° C.

7. Un procédé selon l'une quelconque des revendications précédentes, caractérisé en ce que la solution aqueuse de nitrate est une solution aqueuse ayant une molarité de 3.

8. Un procédé selon l'une quelconque des revendications précédentes, caractérisé en ce que la pression est inférieure à 100 MPa.

9. Un procédé selon la revendication 8, caractérisé en ce que la pression est pratiquement de 75 MPa.

10. Un procédé selon l'une quelconque des revendications précédentes, caractérisé en ce que le monocristal de carbonate de calcium est déposé sur une paroi d'une enceinte sous pression.

11. Un procédé selon l'une quelconque des revendications 1 à 9, caractérisé en ce qu'on fait croître le monocristal de carbonate de calcium sur un cristal germe.

12. Un procédé selon l'une quelconque des revendications 1 à 9, caractérisé en ce qu'on accomplit la synthèse hydrothermique dans une enceinte sous pression, la matière de départ étant placée dans la partie inférieure de l'enceinte sous pression, tandis qu'un cristal germe est placé dans la partie supérieure de l'enceinte sous pression.

13. Un procédé selon la revendication 12, caractérisé en ce qu'on maintient le cristal germe à une température inférieure d'environ 50° C à la température de la partie inférieure de l'enceinte sous pression, et on fait croître le monocristal sur le cristal germe.

14. Un procédé selon la revendication 12 ou 13, caractérisé en ce qu'un séparateur est placé dans la solution aqueuse de nitrate, entre la matière de départ et le cristal germe.

**Patentansprüche**

1. Verfahren zur Herstellung von Kalziumkarbonateinkristallen, bei dem der Kalziumkarbonateinkristall durch Hydrothermalsynthese gezüchtet wird, bei der ein aus Kalziumkarbonatkristallmaterial in einem Lösungsmittel bestehendes Ausgangsmaterial erhitzt und unter Druck gesetzt wird,
**dadurch gekennzeichnet,**
daß man als Lösungsmittel eine Nitratlösung verwendet.

2. Verfahren nach Anspruch 1,
**dadurch gekennzeichnet,** daß die Nitratlösung eine wässerige Alkalinitratlösung ist.

3. Verfahren nach Anspruch 2,
**dadurch gekennzeichnet,** daß die wässerige Nitratlösung eine Natriumnitratlösung, eine Kaliumnitratlösung oder eine Lithiumnitratlösung ist.

7

4. Verfahren nach einem der vorhergehenden Ansprüche,
   **dadurch gekennzeichnet,** daß die Synthesetemperatur in dem Bereich von 300° C bis 500° C liegt.

5. Verfahren nach einem der vorhergehenden Ansprüche,
   **dadurch gekennzeichnet,** daß die Synthesetemperatur höher als 370° C ist.

6. Verfahren nach einem der vorhergehenden Ansprüche,
   **dadurch gekennzeichnet,** daß die Synthesetemperatur unter 420° C liegt.

7. Verfahren nach einem der vorhergehenden Ansprüche,
   **dadurch gekennzeichnet,** daß die wässerige Nitratlösung eine 3-molare wässerige Lösung ist.

8. Verfahren nach einem der vorhergehenden Ansprüche,
   **dadurch gekennzeichnet,** daß der Druck kleiner als 1000 kg/cm² ist..

9. Verfahren nach Anspruch 8,
   **dadurch gekennzeichnet,** daß der Druck im wesentlichen 750 kg/cm² beträgt.

10. Verfahren nach einem der vorhergehenden Ansprüche,
    **dadurch gekennzeichnet,** daß der Kalziumkarbonateinkristall auf einer Wand eines Druckbehälters abgeschieden wird.

11. Verfahren nach einem der Ansprüche 1 bis 9,
    **dadurch gekennzeichnet,** daß der Kalziumkarbonateinkristall an einem Keimkristall gezüchtet wird.

12. Verfahren nach einem der Ansprüche 1 bis 9,
    **dadurch gekennzeichnet,** das die Hydrothermalsynthese in einem Druckbehälter durchgeführt wird, wozu das Ausgangsmaterial im unteren Bereich des Druckbehälters und ein Keimkristall im oberen Bereich des Druckbehälters plaziert wird.

13. Verfahren nach Anspruch 12,
    **dadurch gekennzeichnet,** daß der Keimkristall auf einer Temperatur gehalten wird, die im wesentlichen um 50° C unter der Temperatur des unteren Bereiches des Druckbehälters liegt, wobei der Einkristall an dem Keimkristall gezüchtet wird.

14. Verfahren nach Anspruch 12 oder 13,
    **dadurch gekennzeichnet,** daß zwischen dem Ausgangsmaterial und dem Keimkristall ein Diaphragma in der wässerigen Nitratlösung angeordnet ist.

8

FIG. 1

FIG. 2